(19) Europäisches Patentamt

European Patent Office

Office européen des brevets

(11) **EP 1 619 583 A1**

(12) **EUROPEAN PATENT APPLICATION**
published in accordance with Art. 158(3) EPC

(43) Date of publication:
**25.01.2006 Bulletin 2006/04**

(51) Int Cl.:
*G06F 12/00* (1985.01)    *G06F 12/02* (1985.01)
*G06F 12/06* (1985.01)    *G06K 17/00* (1968.09)

(21) Application number: **04728233.0**

(22) Date of filing: **19.04.2004**

(86) International application number:
**PCT/JP2004/005575**

(87) International publication number:
**WO 2004/097650 (11.11.2004 Gazette 2004/46)**

(84) Designated Contracting States:
**AT BE BG CH CY CZ DE DK EE ES FI FR GB GR HU IE IT LI LU MC NL PL PT RO SE SI SK TR**
Designated Extension States:
**AL HR LT LV MK**

(30) Priority: **25.04.2003 JP 2003121179**

(71) Applicant: **MATSUSHITA ELECTRIC INDUSTRIAL CO., LTD.**
**Kadoma-shi, Osaka 571-8501 (JP)**

(72) Inventors:
• **SAITOU, Hiroshi**
  **Osaka 591-8025 (JP)**
• **OKADA, Takanori**
  **Toyonaki-shi, Osaka 560-0033 (JP)**
• **HOSHINO, Hiromasa**
  **Osaka 572-0055 (JP)**
• **HORITA, Seiji**
  **Osaka 582-0007 (JP)**

(74) Representative: **Schorr, Frank Jürgen et al**
**Diehl & Partner,**
**Augustenstrasse 46**
**80333 München (DE)**

(54) **DATA RECORDING APPARATUS**

(57)    The present invention is a data recording device that can record data at a high speed into a semiconductor memory pack device including a plurality of flash memories that operate in parallel. The data recording device that records data into the semiconductor memory pack device including the plurality of flash memories that perform recording operations in parallel is provided with a file management portion for managing data that is to be recorded into the semiconductor memory pack device as a file, in which the file management portion sets a data recording unit of data that is to be supplied to the semiconductor memory pack device to a common multiple of a size obtained by adding up the sizes of the erase blocks of the plurality of flash memories and a data management size (a cluster size) of the file management portion.

FIG. 3

**Description**

Technical Field

The present invention relates to a device for recording and reproducing video or audio using a semiconductor memory medium.

Background Art

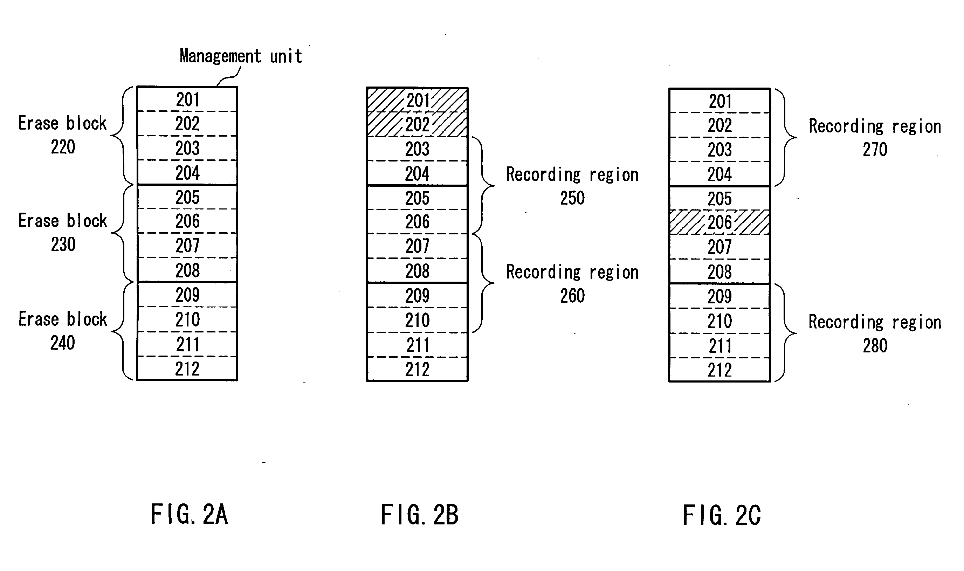

Recently, semiconductor memory cards using a flash memory are becoming widespread. A flash memory is a non-volatile memory that can record and erase data electrically and that retains the recorded data even when the power source is disconnected. Semiconductor memory cards do not include a mechanical driving portion, which is necessary for conventional tape devices and disk devices. Therefore, semiconductor memory cards are compact, light, and shock-resistant, so that they are used in various applications such as digital cameras. However, semiconductor memory cards cannot record high-quality moving images or audio satisfactorily, since the storage capacity per semiconductor memory card is small and their recording/reproducing data transfer rate is low.
To address this problem, conventional examples include a semiconductor memory pack device in which a plurality of semiconductor memory cards are combined in order to improve the storage capacity and the transfer rate.
For example, a semiconductor memory pack device that is disclosed in JP 2000-207137A can record data onto a plurality of semiconductor memory cards simultaneously, so that the recording transfer rate can be increased.
Generally, most conventional semiconductor memory cards are provided with an internal flash memory in which data of a certain size called an "erase block" is erased electrically all at once. Herein, in order to record data that is smaller than the erase block, data in the block is first read out and retained, the data in the block is erased all at once, and then the retained data is partially updated to the recording data and is written back into the block. This operation is called "read-modify-write," and it is a cause for the recording operation becoming complicated and the transfer rate being lowered. In order to record data at a high transfer rate, it is necessary to avoid such a partial data update of the erase block. Thus, the size of the data that is to be recorded should be the same as, or an integral multiple of, the size of the erase block. Furthermore, an address from which the data is recorded has to be matched with the start of the erase block.
In semiconductor memory pack devices in which a plurality of semiconductor memory cards are combined, like the one disclosed in JP 2000-207137A, in order to record data simultaneously onto the plurality of semiconductor memory cards, the data is recorded at the size of the erase block of one semiconductor memory card multiplied by the number of semiconductor memory cards. As described above, in a recording device using a plurality of semiconductor memory cards, it is necessary to enlarge the amount of data that is to be recorded in one recording operation so as to record the data at a high transfer rate.
On the other hand, in order to manage the recorded data as a file, a means or a method for managing data, that is, a so-called file system is generally necessary. The file system generally manages files in units of a certain data size such as a sector or a cluster. However, since the size of a sector or a cluster is generally small, the size of one sector or one cluster is sometimes insufficient for a large data unit such as described above. In such a case, the file system needs to record the data for a continuous plurality of sectors or clusters as one group into the above-described device.
However, in conventional semiconductor memory pack devices using semiconductor memory cards, there are various problems when a unit of recording data does not match a unit of data that is managed by the file system. Hereinafter, these problems will be described in detail with reference to FIG. 2.
FIGS. 2A to 2C show recording regions in a conventional semiconductor memory pack device. In FIG. 2, numeral 201 denotes a management unit. The management unit corresponds to a sector or a cluster of the file system. Each of numerals 202 to 212 denotes a management unit that has the same size as the management unit 201. Furthermore, in FIG. 2A, an erase block 220 is constituted by the management units 201 to 204, and is a unit that is erased electrically all at once. Similarly, an erase block 230 is constituted by the management units 205 to 208, and an erase block 240 is constituted by the management units 209 to 212. In FIG. 2B, a recording region 250 is a recording region that is used when recording data, and is constituted by the management units 203 to 206. Similarly, a recording region 260 is constituted by the management units 207 to 210. In FIG. 2C, a recording region 270 is constituted by the management units 201 to 204, and a recording region 280 is constituted by the management units 209 to 212. The management units 201 and 202 in FIG. 2B and the management unit 206 in FIG. 2C that are marked with diagonal lines show a state in which data has been already recorded, and there is a file in these management units.
The conventional problems will be described with reference to the above-described FIG. 2. In FIG. 2A, the management units 201 to 212 are not used yet. In this case, in order to record data into the semiconductor memory pack device at the highest transfer rate, it is preferable to record the data in units of the erase block and at continuous addresses. Since data in a semiconductor memory medium is erased electrically all at once in units of an erase block in the above-described manner, a read-modify-write operation can be prevented by recording data in data units that match this block size. Furthermore, if data is recorded in units of the erase block and at continuous addresses, some types of semiconductor memory cards arrange their internal processing in such a manner that the recording operations are performed in parallel. These types of media record data at a higher transfer rate. Therefore, an ideal recording method for realizing a high transfer rate in FIG. 2A is to set the data recording unit to the size obtained by adding up the sizes of the management units 201 to 204, and to record data into the erase blocks 220, 230, and 240 in this order.

However, in FIG. 2B, the management units 201 and 202 already contain recorded data as a file. Since the file system can create a file at the size of the management unit, in the case of an exchange medium, other access devices sometimes create such a small file. In this case, when recording data at the size of the erase block, the data is first recorded into the recording region 250, and then the data is recorded into the recording region 260. When the data is recorded into the recording region 250, since not only the management units 203 and 204 into which the data is actually to be recorded, but also the management units 201 and 202 into which data has already recorded are included in the same erase block, a read-modify-write operation such as described above occurs, which results in a low recording transfer rate. Furthermore, when the data is recorded into the recording region 260, since the data has been recorded into the preceding recording region 250, the management units 205 and 206 are in a recorded state. Thus, a read-modify-write operation occurs also when the data is recorded into the management units 207 and 208. Hereinafter, this phenomenon occurs repeatedly.

Thus, even when the data recording unit is set to match the erase block unit, if an address from which recording starts does not match a boundary of the erase block, a read-modify-write operation occurs, which results in a low recording transfer rate.

Furthermore, in FIG. 2B, when data is recorded into the recording region 250, data that has been already recorded into the management units 201 and 202 is temporarily read out and retained, and is written back into the management units after the blocks are erased all at once, internally in the semiconductor memory medium. During this process, when an error such as a noise being mixed into or the power source being disconnected occurs, the data that has been already recorded into the management units 201 and 202 might be destroyed. In this manner, when a read-modify-write operation occurs, not only the recording transfer rate is lowered, but also data that has been already recorded might be destroyed if an error occurs.

In FIG. 2C, the management unit 206 contains already recorded data. In such a case, data of the same size as the erase block is first recorded into the recording region 270. Then, in order to avoid a read-modify-write operation, data is recorded not into the erase block including the management unit 206 but into the recording region 280 that corresponds to the next erase block, that is, the management units 209 to 212. Although this method eliminates a read-modify-write operation, it has the following problems.

First, in FIG. 2C, in order to avoid the management unit 206 that contains the already recorded data, the management units 205, 207 and 208 are not used for recording although they are free regions. This means that recording regions are wasted. When there are a large number of erase blocks including partially recorded management units such as the management units 205 to 208, a so-called fragmented state results. In order to record data at a high transfer rate, these regions cannot be used for recording, and thus the capacity of the recording medium cannot be used effectively.

Furthermore, in FIG. 2C, there is a space between the recording regions 270 and 280, and thus their addresses become discontinuous. When addresses are discontinuous, it is impossible to record data at a high transfer rate as described above.

Furthermore, ordinary file systems need to update file management information every time when data is recorded for several sectors or clusters. This management information is, for example, a table showing a usage state of sectors or clusters, bitmap data, or information of the size of the file into which the data is being recorded. When the file management information is frequently updated, even if the recording is interrupted because of a power source disconnection or the like, it becomes possible to restore the file to a state just before the power source disconnection to the extent possible. However, in a semiconductor memory medium using, for example, a flash memory, the number of rewriting operations is limited, and thus when management information is frequently updated, the rewriting life of the semiconductor memory medium becomes short.

Disclosure of Invention

Therefore, with the foregoing in mind, it is an object of the present invention to provide a data recording device that can record data at a high speed into a semiconductor memory pack device including a plurality of flash memories that operate in parallel.

In order to solve this problem, the data recording device according to the invention uses the following means.

First, a data recording device of the invention is a data recording device that records data into a semiconductor memory pack device that includes a plurality of flash memories performing recording operations in parallel, the data recording device including: a file management portion for managing data that is to be recorded into the semiconductor memory pack device as a file; in which the file management portion sets a data recording unit of data that is supplied to the semiconductor memory pack device to a common multiple of a size obtained by adding up the sizes of erase blocks of the plurality of flash memories and a data management size of the file management portion.

Consequently, a read-modify-write operation that conventionally has been an impediment to high speed recording can be prevented, and as a result, the number of rewriting operations of the semiconductor memory cards can be reduced.

Second, it is preferable that in the data recording device of the invention according to the first aspect, a data recording unit is an integral multiple of the size obtained by adding up the sizes of the erase blocks of the plurality of flash memories, and a data management unit of the file management portion has the same size as the data recording unit.

Consequently, a read-modify-write operation that conventionally has been an impediment to high speed recording can be prevented, and as a result, the number of rewriting operations of the semiconductor memory cards can be reduced.

Third, it is preferable that in the data recording device of the invention according to the first or second aspect, the file management portion lets each data recording unit include only data of the same file.

By setting the data recording unit to include only data of the same file in this manner, the data of the same file is written into the plurality of flash memories in parallel. Consequently, when reading out this data from the flash memories, it is possible to read out the data at a high speed by reading out in parallel.

Fourth, it is preferable that in the data recording device of the invention according to the first or second aspect, the file management portion records data only when the semiconductor memory pack device includes free space that is equivalent to the data recording unit.

Consequently, the boundaries of the erase blocks of the flash memories always match the boundaries of the data recording units, and thus a read-modify-write operation that has been conventionally an impediment to high speed recording can be prevented more effectively, and as a result, the number of rewriting operations of the semiconductor memory cards can be reduced.

Fifth, it is preferable that in the data recording device of the invention according to the first or second aspect, when data of different files is recorded in the data recording unit, the file management portion sorts recording data in such a manner that the data recording unit includes only data of the same file.

Consequently, a read-modify-write operation that conventionally has been an impediment to high speed recording can be prevented, and as a result, the number of rewriting operations of the semiconductor memory cards can be reduced. Furthermore, by sorting recording data in such a manner that the data recording unit includes only data of the same file, the data of the same file is recorded into the plurality of flash memories in parallel. Thus, when reading out this data from the flash memories, it is possible to read out the data at a high speed by reading out in parallel.

Sixth, it is preferable that in the data recording device of the invention according to the first or second aspect, the semiconductor memory pack device is provided with a region into which file management information of the file management portion is recorded, and when the file management portion records at least two files of an audio data file and a video data file simultaneously and in parallel into the semiconductor memory pack device, the file management information that is recorded in the semiconductor memory pack device is updated at a time when an amount of audio data accumulated as data that is to be supplied to the semiconductor memory pack device becomes an integral multiple of the data recording unit.

Consequently, a read-modify-write operation that conventionally has been an impediment to high speed recording can be prevented, and as a result, the number of rewriting operations of the semiconductor memory cards can be reduced. Furthermore, since recording of audio data, which has a low bit rate, triggers the backup of the file management information, the number of rewriting the file management information in the semiconductor memory pack device is not increased needlessly.

Seventh, it is preferable that in the data recording device of the invention according to the first or second aspect, when the file management portion records an MPEG stream into a file, the file management information of the file management portion is updated at a time when an amount of recorded data becomes an integral multiple of 1 GOP.

Eighth, it is preferable that in the data recording device of the invention according to the first or second aspect, the flash memories are mounted on the semiconductor memory pack device as semiconductor memory cards.

Ninth, a data recording device of the invention is a data recording device that records data according to a FAT file system into a semiconductor memory pack device that includes a plurality of flash memories, in which the FAT file system manages the total number of sectors obtained by adding the number of existing sectors in the semiconductor memory pack device and the number of non-existing virtual sectors; and in which by storing a value that does not indicate a free region in FAT entries of clusters corresponding to the non-existing virtual sectors, the non-existing sectors will not be written into.

Tenth, it is preferable that in the data recording device of the invention according to the ninth aspect, all bits in the FAT entry are set to 1 indicating an end of file, as the value that does not indicate a free region.

As described above, with the present invention, data can be recorded into a semiconductor memory pack device that includes a plurality of semiconductor memory cards at a high speed, and the rewriting life of the built-in semiconductor memory cards can be extended.

Brief Description of Drawings

FIG. 1 is a diagram showing a data recording device according to Embodiment 1 of the present invention, and a semiconductor memory pack device.

FIG. 2 shows diagrams of recording regions of a conventional semiconductor memory pack device.

FIG. 3 is a diagram showing how a data recording unit, erase blocks, and a cluster are allocated according to Embodiment 1 of the invention.

FIG. 4 is a diagram showing how a data recording unit, erase blocks, and clusters are allocated according to Embodiment 2 of the invention.

FIG. 5 is a diagram showing how data recording units, erase blocks, and clusters are allocated according to Embodiment 3 of the invention.

FIG. 6 is a diagram showing data recording units and a recording arrangement of files before a sorting according to Embodiment 4 of the invention.

FIG. 7 is a diagram showing data recording units and a file recording arrangement after the sorting according to Embodiment 4 of the invention.

FIG. 8 is a block diagram showing a method for reproducing a real-time data file according to Embodiment 5 of the invention.

FIG. 9 is a block diagram showing the method for reproducing a real-time data file according to Embodiment 5 of the invention.

FIG. 10 is a block diagram showing the method for reproducing a real-time data file according to Embodiment 5 of the invention.

FIG. 11 is a block diagram showing a method for reproducing a real-time data file according to Embodiment 6 of the invention.

FIG. 12 is a diagram showing a boot sector of a FAT that is regulated by ISO/IEC 9293.

FIG. 13 is a block diagram showing a functional configuration of the data recording device according to Embodiment 1 of the invention.

FIG. 14 is a diagram showing a method for sorting data within a data recording unit according Embodiment 4 of the invention.

Best Mode for Carrying Out the Invention

Hereinafter, embodiments of the present invention will be described with reference to the accompanying drawings.

*Embodiment 1*

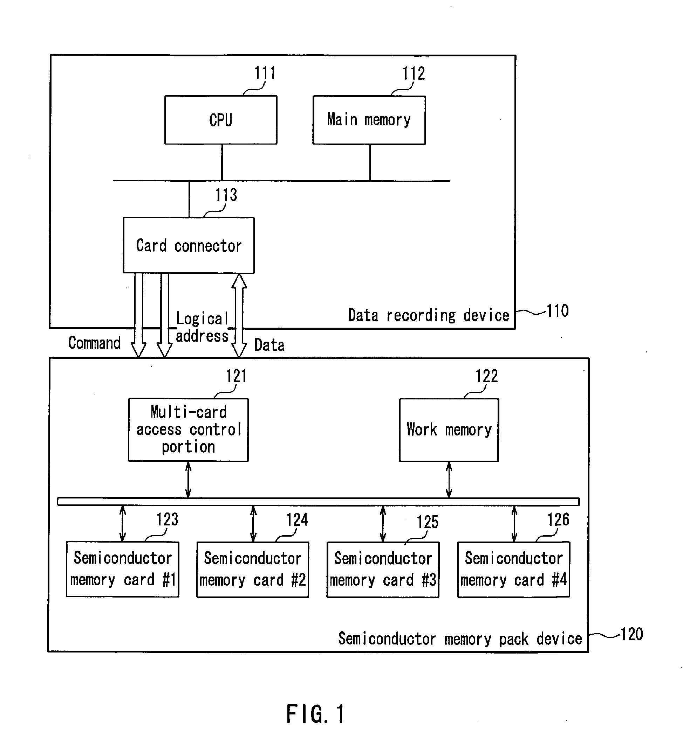

First, configurations of a data recording device according to an embodiment of the invention and a semiconductor memory pack device will be described with reference to FIG. 1. In FIG. 1, numeral 110 denotes a data recording device that gives an instruction to record data, and numeral 120 denotes a semiconductor memory pack device into which the data is recorded. The data recording device 110 is a device that records data into the semiconductor memory pack device 120, and may be a personal computer, a video camera, a disk recorder, or a digital camera, for example, although the data recording device 110 is not limited to these. The data recording device 110 is provided with such hardware as a CPU 111, a main memory 112, and a card connector 113. The CPU 111 performs arithmetic processing and controls an operation of the entire device. The main memory 112 temporarily stores data that is to be recorded into the semiconductor memory pack device 120, software that controls an operation of the data recording device 110, and a result of arithmetic processing performed by the CPU 111. The card connector 113 connects the data recording device 110 and the semiconductor memory pack device 120.

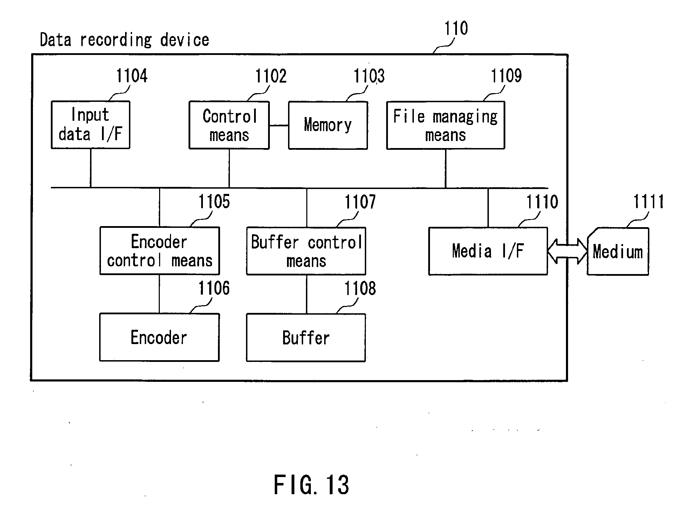

Next, a functional configuration of the data recording device 110 according to this embodiment will be described with reference to FIG. 13. FIG. 13 is a block diagram showing the functional inner configuration of the data recording device 110. In FIG. 13, numeral 1102 denotes a control portion, numeral 1103 denotes a memory, numeral 1104 denotes an input data I/F (interface), numeral 1105 denotes an encoder control portion, numeral 1106 denotes an encoder, numeral 1107 denotes a buffer control portion, numeral 1108 denotes a buffer, numeral 1109 denotes a file management portion, and numeral 1110 denotes a media I/F.

The control portion 1102 corresponds to the CPU 111 in FIG. 1, and controls the entire data recording device 110 using the memory 1103, which corresponds to the main memory 112 in FIG. 1. The media I/F 1110 interfaces with the semiconductor memory pack device 120, and corresponds to the card connector 113 in FIG. 1.

The input data I/F 1104 receives data that has been input from the outside. The encoder control portion 1105 receives the data that has been input through the input data I/F 1104, encodes the data by controlling the encoder 1106, and sends the encoded data to the buffer control portion 1107. It should be noted that the encoder control portion 1105 can obtain information from the encoder 1106 and forward the information to the control portion 1102. Examples of the information from the encoder 1106 include, for example, information indicating that data for 1 GOP (group of pictures) is completely encoded when encoding video data into MPEG (moving pictures coding experts group) format.

The buffer control portion 1107 stores the encoded data that has been received from the encoder control portion 1105 in separate regions of the buffer 1108 according to the data types. The buffer control portion 1107 monitors the amount of the data that is stored in the buffer 1108, and sends a message to the control portion 1102 when the amount has reached a certain level. When receiving the message, the control portion 1102 sends a data recording request to the file management portion 1109.

Generally, the file management portion 1109 is a so-called "file system" serving as a function of an operating system, and manages files that are recorded in the semiconductor memory pack device 120. The file management portion 1109 reads out file system management information from the semiconductor memory pack device 120 via the media I/F 1110, and stores the information in the memory 1103. When receiving the data recording request from the control portion 1102, the file management portion 1109 searches for a free region with reference to the file system management information. When a region is found, the file management portion 1109 sends a data recording command to the semiconductor memory pack device 120 to record the data into the region. Simultaneously with this process, the file management portion 1109 writes information of the recorded data, such as the recording position or the data amount, into the file system management information that is stored in the memory 1103.

The semiconductor memory pack device 120 is provided with semiconductor memory cards 123 to 126 using a flash memory, a multi-card access control portion 121 controlling these four semiconductor memory cards 123 to 126, and a work memory 122 temporarily storing data that is to be recorded onto the memory cards 123 to 126. The semiconductor memory cards 123 to 126 are assigned the numerals #1 to #4 respectively.

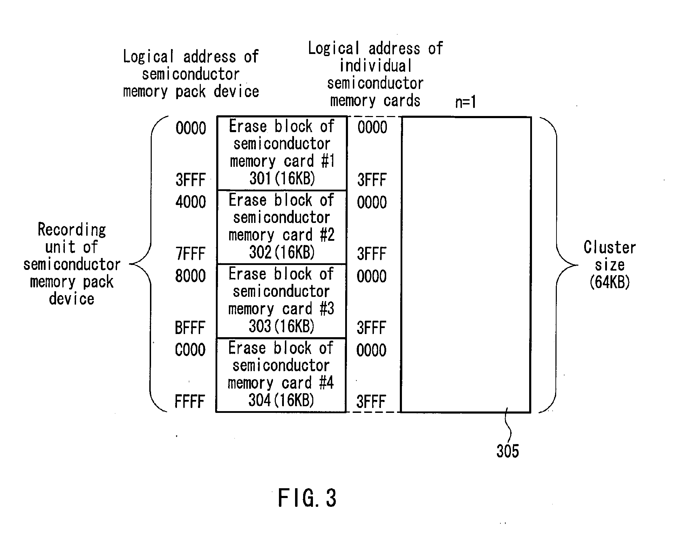

Next, a data recording operation by the data recording device 110 according to this embodiment will be described with reference to FIG. 3. FIG. 3 shows a state in which logical addresses of the four semiconductor memory cards 123 to 126 are mapped to continuous logical addresses of the semiconductor memory pack device 120, and in which a cluster, which is a data management unit of the file management portion 1109, is allocated to the continuous logical addresses of the semiconductor memory pack device 120.

A method for mapping of the logical addresses of the semiconductor memory cards 123 to 126 is as follows. The four semiconductor memory cards 123 to 126 that are built into the semiconductor memory pack device 120 are interleaved in units of the erase block size (16 KB) are arranged in order from #1 to #4 of the semiconductor memory cards 123 to 126, and then are mapped to continuous logical addresses of the semiconductor memory pack device 120. Since the four semiconductor memory cards 123 to 126 that are built into the semiconductor memory pack device 120 simultaneously perform recording operations in parallel, data is recorded into the semiconductor memory pack device 120 in units of these continuous addresses, which have a size of 16 KB×4=64 KB. The size of a cluster 305, which is a data management unit of the file management portion 1109 of the data recording device 110, matches this data recording unit. More specifically, one cluster is allocated to continuous logical addresses that have a size of 64 KB in the semiconductor memory pack device 120. Hereinafter, a recording operation by the data recording device 110 for the case that the cluster size is set to 64 KB will be described.

In the data recording device 110, the file management portion 1109 is realized by software that controls an operation of the CPU 111. The file management portion 1109 divides data that is to be recorded into the semiconductor memory pack device 120 into portions with the same size as the cluster serving as the data management unit (64 KB in this case). Furthermore, the file management portion 1109 searches for a free region for one cluster in the memory space of the semiconductor memory pack device 120, and hands over logical addresses of a found free region and the data that is to be recorded together with a recording command to the semiconductor memory pack device 120.

When receiving the recording command from the data recording device 110, the semiconductor memory pack device 120 temporarily stores the data for one cluster that is to be recorded together with the recording command in the work memory 122. Furthermore, in the semiconductor memory pack device 120, the multi-card access control portion 121 converts the logical addresses of the semiconductor memory pack device 120 that have been specified together with the recording command into individual logical addresses of the semiconductor memory cards 123 to 126 as shown in FIG. 3. The multi-card access control portion 121 spreads the data for one cluster that is temporarily stored in the work memory 122 into the individual logical addresses of the semiconductor memory cards 123 to 126 obtained by this conversion, and then records the data in parallel.

As described above, in this embodiment, the size of one cluster, which is the smallest unit with which the file management portion 1109 of the data recording device 110 manages data, matches the size obtained by adding up the sizes of the erase blocks of the four semiconductor memory cards that are built into the semiconductor memory pack device 120 (64 KB), so that a read-modify-write operation that conventionally has been an impediment to high speed recording can be prevented, and as a result, the number of rewriting operations of the semiconductor memory cards can be reduced. Furthermore, the semiconductor memory pack device 120 records data simultaneously onto its four built-in semiconductor memory cards 123 to 126 in parallel, and thus the data can be recorded four times faster than in the case of only one semiconductor memory card.

Embodiment 1 was described for an example of the semiconductor memory pack device including four semiconductor memory cards that operate in parallel. However, it should be noted that the number of semiconductor memory cards that are built into the semiconductor memory pack device is not limited to four in the data recording device according to the invention. Also, it is not necessary that all of the built-in semiconductor cards operate in parallel, and for example, four built-in semiconductor memory cards may operate in two pairs in parallel. Furthermore, Embodiment 1 was described for an example in which the four erase blocks are allocated to one cluster. However, the number is not limited to four as long as setting the number to an integral multiple of the total number of erase blocks of the semiconductor memory cards that are built into the semiconductor memory pack device. The size of one erase block is not limited to 16 KB either. The form of the built-in semiconductor memory is not limited to a card, and the technical field of the invention includes semiconductor memories that are mounted in form of a chip.

Furthermore, Embodiment 1 was described for an example of a configuration in which a plurality of semiconductor memory cards operate in parallel in a semiconductor memory pack device. However, the invention can also be applied to, for example, a configuration in which a plurality of flash memories operate in parallel in a semiconductor memory card. More specifically, according to the invention, the size obtained by adding up the sizes of the erase blocks of the plurality of flash memories that operate in parallel matches the size of one cluster, which is the smallest unit with which the file management portion 1109 manages data.

*Embodiment 2*

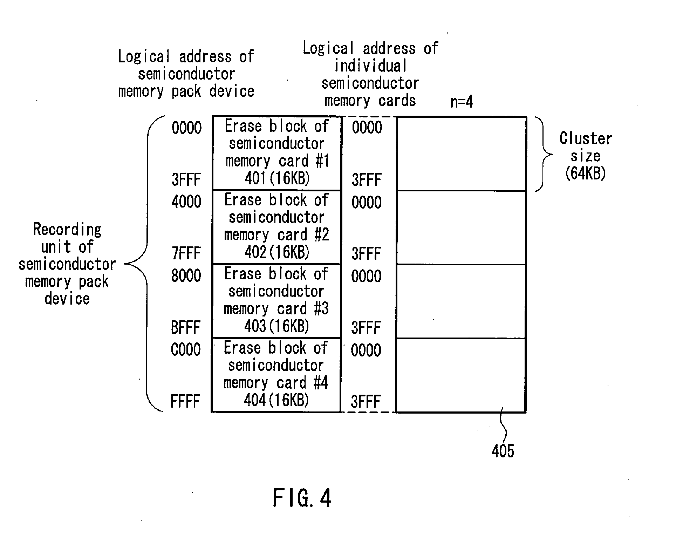

Another embodiment of the invention will be described with reference to FIGS. 1 and 4. The same numerals as Embodiment 1 are used for structures that serve a similar function as described in Embodiment 1, and detailed explanations of such structures are omitted.

FIG. 4 shows a state in which logical addresses of the four built-in semiconductor memory cards 123 to 126 are mapped to continuous logical addresses of the semiconductor memory pack device 120, and in which clusters, which are data management units of the file management portion 1109, are allocated to the continuous logical addresses of the semiconductor memory pack device 120. The four semiconductor memory cards 123 to 126 that are built into the semiconductor memory pack device 120 are interleaved in units of the erase block size (16 KB), are arranged in order from #1 to #4, and then are mapped to continuous logical addresses of the semiconductor memory pack device 120. Furthermore, since the four semiconductor memory cards 123 to 126 that are built into the semiconductor memory pack device 120 simultaneously perform recording operations in parallel, data is recorded in units of these continuous addresses, which have a size of 16 KB×4=64 KB. In this embodiment, the cluster size that is the data management unit of the file management portion 1109 of the data recording device 110 and the data recording unit are selected in such a manner that the latter is a common multiple of the former. In this case, the size of one cluster is set to 16 KB. Hereinafter, an operation for the case that the cluster size is set to 16 KB will be described.

In the data recording device 110, the file management portion 1109 is realized by software that controls an operation of the CPU 111. The file management portion 1109 divides data that is to be recorded into the semiconductor memory pack device 120 into portions with the same size as the clusters serving as the data management units (16 KB). So far, a similar procedure to the conventional methods for recording data is followed. However, in this embodiment, the file management portion 1109 searches for a free region for the data recording unit (64 KB), that is, four clusters (16 KB×4=64 KB) in the semiconductor memory pack device 120, and hands over logical addresses of a found free region and the data for four clusters together with a recording command to the semiconductor memory pack device 120.

When receiving the recording command from the data recording device 110, the semiconductor memory pack device 120 temporarily stores the data for four clusters in the work memory 122. At the same time, the multi-card access control portion 121 converts the logical addresses of the semiconductor memory pack device 120 that have been specified together with the recording command into individual logical addresses of the four semiconductor memory cards 123 to 126 that are built into the semiconductor memory pack device 120 as shown in FIG. 4. Furthermore, the data for clusters that is temporarily stored in the work memory 122 is divided into four portions, and is recorded in parallel and simultaneously into the respective logical addresses of the semiconductor memory cards 123 to 126 obtained by the above conversion.

As described above, in this embodiment, recording is performed not in units of one cluster (16 KB), which is the smallest unit with which the file management portion 1109 of the data recording device 110 manages data, but in units of four clusters (64 KB), which is a common multiple of the size obtained by adding up the sizes of the erase blocks (64 KB) of the four semiconductor memory cards 123 to 126 that are built into the semiconductor memory pack device 120 and the size of one cluster (16 KB), so that a read-modify-write operation that has been conventionally an impediment to high speed recording can be prevented, and as a result, the number of rewriting operations of the semiconductor memory cards can be reduced. Furthermore, the semiconductor memory pack device 120 records data simultaneously onto its four built-in semiconductor memory cards 123 to 126 in parallel, and thus the data can be recorded four times faster than in the case of only one semiconductor memory card.

Embodiment 2 was described for an example of the semiconductor memory pack device including four semiconductor memory cards. However, according to the invention, the number of semiconductor memory cards that are built into the semiconductor memory pack device is not limited to four, and it is possible to apply the invention in a similar manner to a configuration that includes a plurality of semiconductor memory cards. Also, it is not necessary that all of the built-in semiconductor cards operate in parallel, and for example, four built-in semiconductor memory cards may operate in two pairs in parallel. Furthermore, Embodiment 2 was described for an example in which the four erase blocks are allocated to four clusters. However, a similar effect can be obtained as long as setting the data recording unit to a common multiple of the size obtained by adding up the sizes of the erase blocks of the semiconductor memory cards that are built into the semiconductor memory pack device and the size of one cluster, and recording only data of the same file into one data recording unit. Furthermore, the size of one erase block is not limited to 16 KB. The form of the built-in semiconductor memory is not limited to a card, and the technical field of the invention includes semiconductor memories that are mounted in form of a chip. Furthermore, Embodiment 2 was described for an example of a configuration in which a plurality of semiconductor memory cards operate in parallel in a semiconductor memory pack device. However, the invention also can be applied to, for example, a configuration in which a plurality of flash memories operate in parallel in a semiconductor memory card. More specifically, according to the invention, the data recording unit of the file management portion 1109 is a common multiple of the size obtained by adding up the sizes of the erase blocks of the plurality of flash memories that operate in parallel and the size of one cluster.

*Embodiment 3*

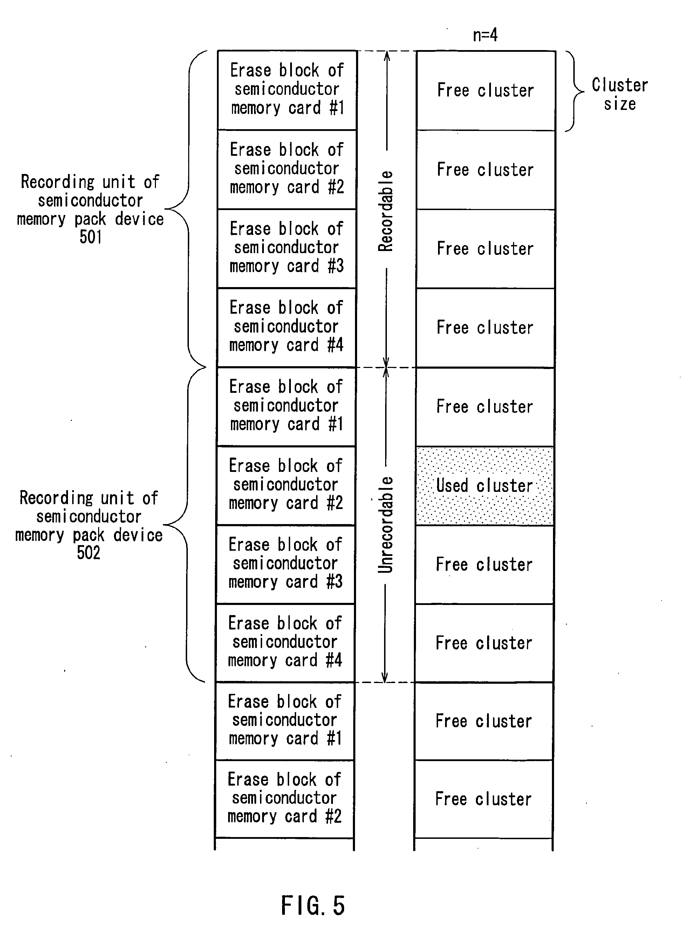

Subsequently, another embodiment of the invention will be described with reference to FIGS. 1 and 5. FIG. 5 shows a relationship of continuous logical addresses of the semiconductor memory pack device 120 and erase blocks (16 KB) of the four semiconductor memory cards 123 to 126 that are mapped to these logical addresses, and a cluster allocation when a data recording unit is set to four clusters (64 KB), which is a common multiple of the size obtained by adding up the sizes of the erase blocks (16 KB×4=64 K) of the semiconductor memory cards 123 to 126, and the size of one cluster (16 KB), which is a data management unit of the file management portion 1109.

In conventional file systems, free regions are searched in units of clusters, which are the data management units. If there is a free region even for one cluster, data for one cluster is recorded at that logical address. However, in the file management portion 1109 of the data recording device 120 according to this embodiment, a data recording unit is set to four clusters, and thus data is not recorded without a continuous free region at least for four clusters. In FIG. 5, a data recording unit 501 of the semiconductor memory pack device 120 is judged to be "recordable" since all of the continuous four clusters are free regions. On the other hand, since a data recording unit 502 includes one already recorded cluster, the cluster together with the other three clusters are not used for recording.

As described above, in this embodiment, data is recorded in such a manner that an alignment of logical addresses at which the entire data for four clusters is recorded always matches a boundary of the data recording unit with a size of 64 KB, by searching for a free region at the data recording unit (64 KB). Therefore, the boundary of the erase blocks of the four semiconductor memory cards reliably matches the boundary of the data recording unit, so that a read-modify-write operation that conventionally has been an impediment to high speed recording can be prevented, and as a result, the number of rewriting operations of the semiconductor memory cards can be reduced.

Embodiment 3 was described for an example of the semiconductor memory pack device including four semiconductor memory cards. However, according to the invention, the number of semiconductor memory cards that are built into the semiconductor memory pack device is not limited to four, and it is possible to apply the invention in a similar manner to a configuration that includes a plurality of semiconductor memory cards. Also, it is not necessary that all of the built-in semiconductor cards operate in parallel, and for example, four built-in semiconductor memory cards may operate in two pairs in parallel. Furthermore, Embodiment 3 was described for an example in which the four erase blocks are allocated to four clusters. However, a similar effect can be obtained as long as setting the data recording unit to a common multiple of the size obtained by adding up the sizes of the erase blocks of the semiconductor memory cards that are built into the semiconductor memory pack device and the size of one cluster, and searching for a free region at the data recording unit. Furthermore, the size of one erase block is not limited to 16 KB. The form of the built-in semiconductor memory is not limited to a card, and the technical field of the invention includes semiconductor memories that are mounted in form of a chip.

*Embodiment 4*

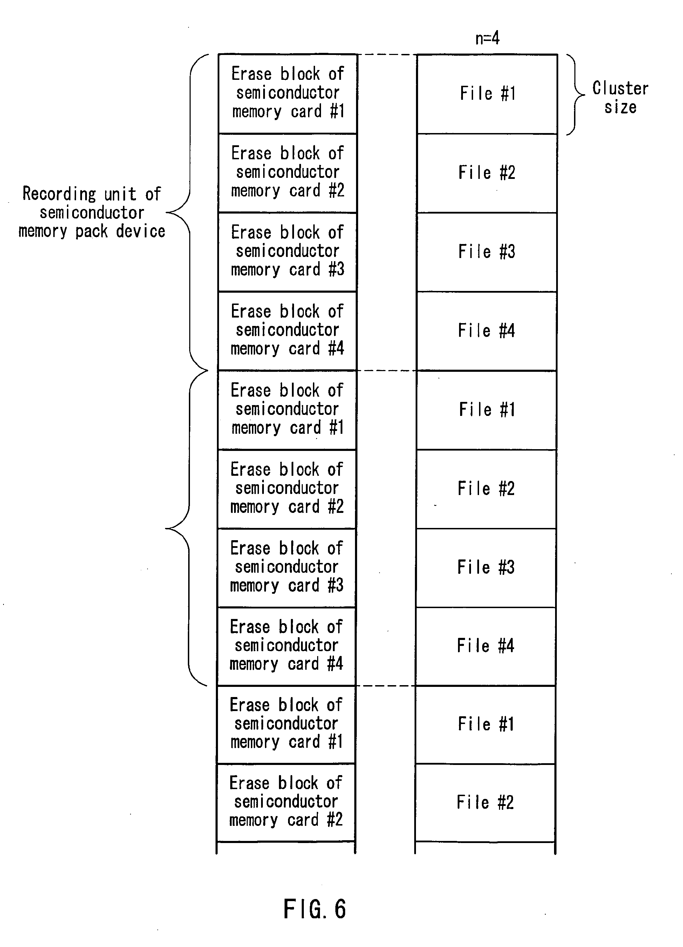

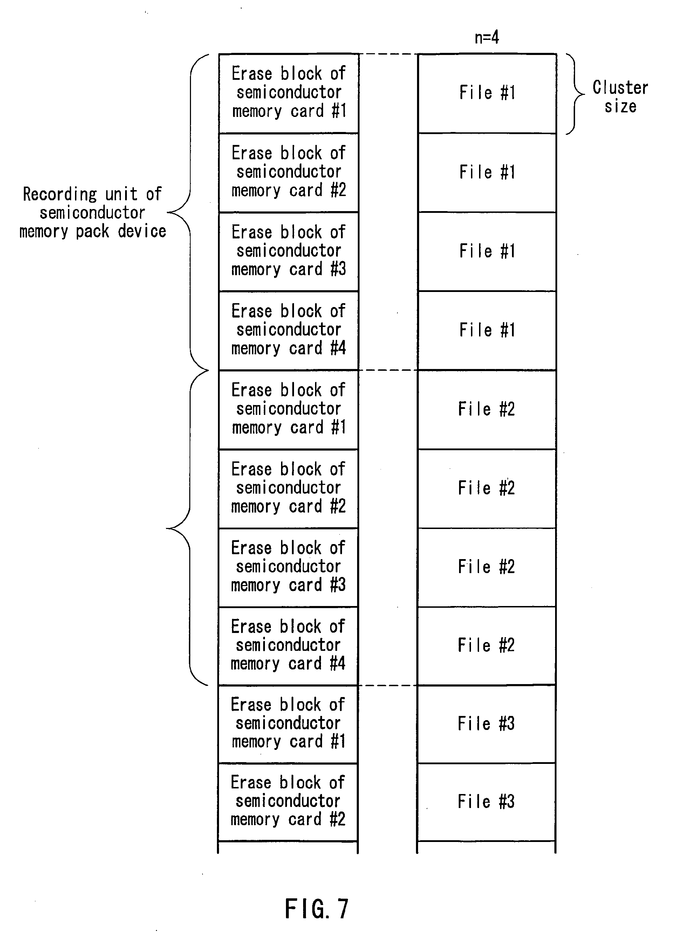

Another embodiment of the invention will be described with reference to FIGS. 1, 6, and 7. FIGS. 6 and 7 show a relationship of erase blocks (16 KB) of the four semiconductor memory cards 123 to 126 that are mapped to continuous logical addresses of the semiconductor memory pack device 120, and a cluster allocation when a data recording unit is set to four clusters (64 KB), which is a common multiple of the size obtained by adding up the sizes of the erase blocks (16 KBx4=64 KB) of the four semiconductor memory cards 123 to 126 operating in parallel and the size of one cluster (16 KB), which is a data management unit of the file management portion 1109.

FIG. 6 shows an example in which files are allocated in units of one cluster by conventional file systems. In the conventional file systems, a cluster is the smallest unit for managing data, and there is no contradiction to recording the data in files as shown in FIG. 6. However, when data is recorded at a cluster size that is smaller than the data recording unit of the semiconductor memory pack device 120 into different files, it is impossible to read out the data four times faster than in the case of only one semiconductor memory card even by operating the four semiconductor memory cards 123 to 126 in parallel. This is because the data in file #1 exists only in the semiconductor memory card #1 that is built into the semiconductor memory pack device 120, and thus it is impossible to read out the data by operating the four semiconductor memory cards 123 to 126 in parallel, in the example shown in FIG. 6.

On the other hand, FIG. 7 shows an example in which only data of the same file is recorded into one data recording unit of the semiconductor memory pack device 120, although the cluster size is the same as that in FIG. 6. By recording as shown in FIG. 7, for example, it is possible to read out the data in the file #1 by operating the four semiconductor memory cards 123 to 126 in parallel, and thus the data can be read out four times faster than in the case of only one semiconductor memory card.

Therefore, in this embodiment, data of files recorded in cluster sizes that are smaller than the data recording unit of the semiconductor memory pack device 120 as shown in FIG. 6 is sorted in such a manner that the data recording units of the semiconductor memory pack device 120 include only data of the same file as shown in FIG. 7, and thus recording is performed with the maximum effect of parallel operations of the semiconductor memory pack device 120. This recording operation can be carried out only by sorting data in units of clusters, and it is possible to read out the recorded file at a high speed.

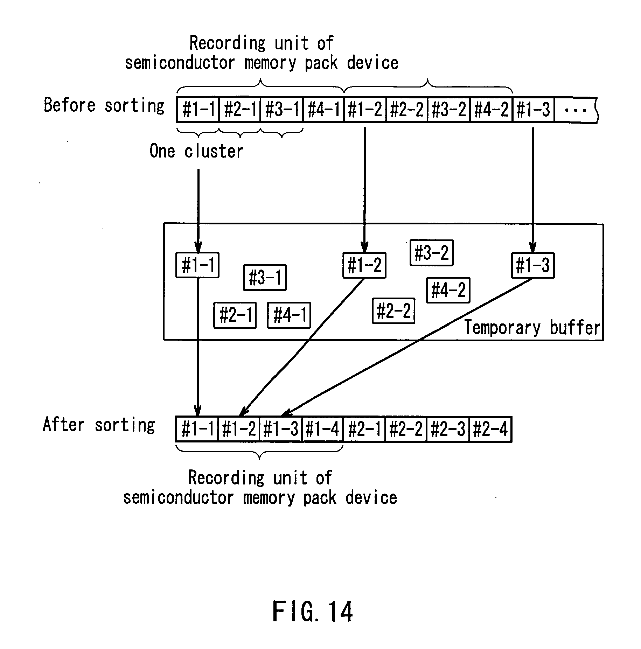

FIG. 14 shows an example of a method for performing the sorting. In a state before the sorting, the files #1 to #4 are recorded cluster by cluster in the recording units of the semiconductor memory pack device 120. In this state, it is impossible to read out the data at a high speed, using a parallel operation of the semiconductor memory pack device 120. Thus, the individual clusters are read out to a temporary buffer, clusters of the same file are selected and recorded again into the same recording unit of the semiconductor memory pack device 120, and in this manner the sorting is performed. Examples of the temporary buffer include, for example, the main memory 112 of the data recording device 110 or the work memory 122 of the semiconductor memory pack device 120. It is possible to perform the sorting process if the temporary buffer has a capacity that covers at least a recording unit of the semiconductor memory pack device 120. After performing this sorting, it is possible to write and read files at a high speed, using a parallel operation of the semiconductor memory pack device 120.

The above-described sorting of recording data may be performed automatically at a predetermined timing such as when the semiconductor memory pack device 120 is connected to the data recording device 110, or when the data recording device 110 has performed a certain operation. Examples of the certain operation include, for example, a completion of image-taking when the data recording device 110 is a digital camera or a video camera.

Embodiment 4 was described for an example of the semiconductor memory pack device including four semiconductor memory cards. However, according to the invention, the number of semiconductor memory cards that are built into the semiconductor memory pack device is not limited to four, and it is possible to apply the invention in a similar manner to a configuration that includes a plurality of semiconductor memory cards. Also, it is not necessary that all of the built-in semiconductor cards operate in parallel, and for example, four built-in semiconductor memory cards may operate in two pairs in parallel. Furthermore, Embodiment 4 was described for an example in which the four erase blocks are allocated to four clusters. However, a similar effect can be obtained as long as setting the data recording unit to a common multiple of the size obtained by adding up the sizes of the erase blocks of the semiconductor memory cards that are built into the semiconductor memory pack device and the size of one cluster, and sorting the recording data in such a manner that only data of the same file is recorded into one data recording unit. Furthermore, the size of one erase block is not limited to 16 KB. The form of the built-in semiconductor memory is not limited to a card, and the technical field of the invention includes semiconductor memories that are mounted in the form of a chip.

*Embodiment 5*

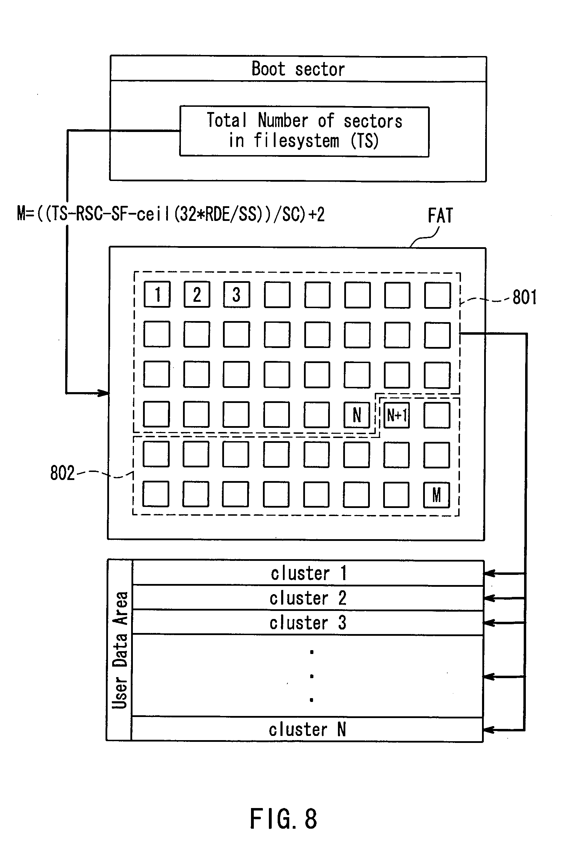

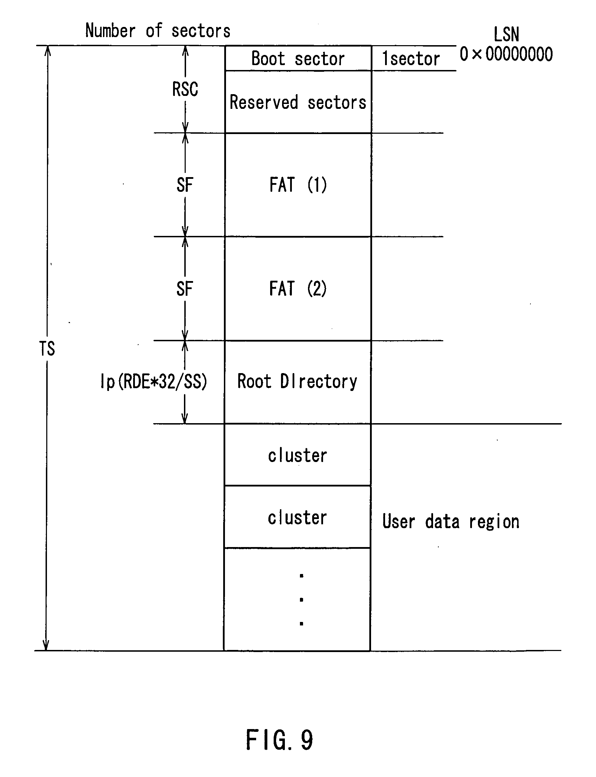

Subsequently, another embodiment of the invention will be described with reference to FIGS. 8 to 10. First, a configuration of a FAT file system will be described with reference to FIGS. 8 and 9.

Generally, in the FAT file system that is regulated by ISO/IEC 9292, file system management information and a user data region are arranged in a logical volume in a storage medium as shown in FIG. 9. The uppermost portion of FIG. 9 shows a logical sector number 0.

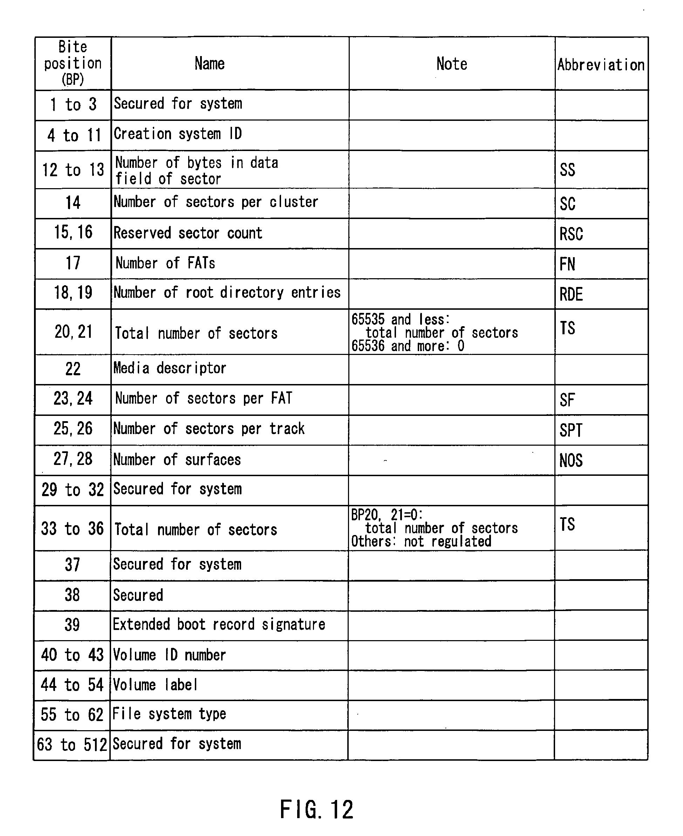

A boot sector is recorded in the logical sector number 0. In the boot sector, information of the entire volume and information relating to the location of management information such as a FAT that is necessary to read out a file described in the user data region or a route entry are recorded. FIG. 12 shows information that should be written in the boot sector according to ISO/IEC 9293, in a FAT 16 file system, which is an example of a FAT file system.

A reserved region is sometimes provided between the FAT in which arrangement information of files in the user data region is written and the boot sector. The number of sectors of the reserved region is listed in the boot sector.

Furthermore, in the FAT file system, a plurality of FATs may be recorded, and the number of FATs and the number of sectors per FAT are listed in the boot sector.

In sectors directly after the one or plurality of FATs, information relating to files that are recorded in the a root directory is provided continuously. The information relating to files is referred to as a "file entry," and is managed in units of 32 bytes. In the file entry, a file name, a file creation time, a file size, a file length, and a first cluster number from which the file is stored are recorded. The maximum number of file entries (the number of entries in the root directory) that are provided in the root directory is listed in the boot sector, and a region of a size corresponding to this value is secured in advance for the root directory entries. The number of entries in the root directory is listed in the boot sector.

The sectors directly after the root directory entry serve as the user data region. The user data region is managed in units of a so-called cluster, which includes one or a plurality of continuous sectors, and all clusters are numbered consecutively from the top.

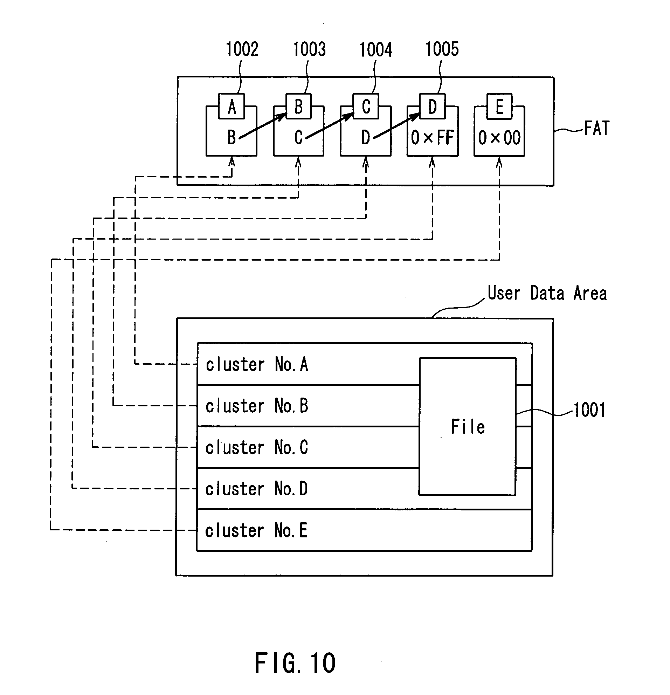

FAT entries corresponding to each of the clusters are prepared in the FAT. Hereinafter, a method for recording a file into the user data regions will be described with reference to FIG. 10.

In this example, a file 1001 that is to be recorded has a size that is equivalent to four clusters in the user data region. In this case, the file system finds four FAT entries in which a particular bit string representing an unallocated state ($0 \times 00$, in the FAT 16 file system) is recorded. For example, when it is found that a bit string representing an unallocated state is recorded in FAT entries (1002 to 1005) corresponding to four clusters No. A, B, C, and D, the file system divides and records the file into the four clusters No. A, B, C, and D in the user data region. Furthermore, in order to record the relationship of the four clusters, the number of next cluster in which the file is stored, that is, the number of cluster B is recorded into the FAT entry 1002 corresponding to the cluster A. In a similar manner, the number of cluster C is recorded into the FAT entry 1003 corresponding to the cluster B, and the number of cluster D is recorded into the FAT entry 1004 corresponding to the cluster C. In the FAT entry 1005 corresponding to the last cluster in which the file is recorded (the cluster D, in this example), a particular bit string representing an end of file (0xFF, in the FAT 16 file system) is recorded. When the file is read out from the user data region, by tracing this chain of the clusters, it is possible to follow the file until its end. A file system that uses 12 bits for each FAT entry is called a FAT 12 file system, a file system that uses 16 bits is called a FAT 16 file system, and a file system that uses 32 bits is called a FAT 32 file system.

The size SF of the space allocated to the entire FAT is listed in the bits 23 and 24 in the boot sector (FIG. 12). Furthermore, the number FE of valid FAT entries included in this space is calculated by the following Formula 1, using TS, which is the total number of sectors listed in the bits 33 to 36 in the boot sector.

Formula 1

$$ ip\left\{ \frac{TS - RSC - SF - ceil\left( \dfrac{32 \times RDE}{SS} \right)}{SC} \right\} + 2 $$

In Formula 1, RSC refers to the number of reserved sectors, SF refers to the number of sectors per FAT, RDE refers to the number of root directory entries, SS refers to the number of bytes in a data field of a sector, and SC refers to the number of sectors per cluster. The function ip(x) returns an integer part of x, and the function ceil(x) returns the minimum integer number that is larger than x. In Formula 1, the function ceil(32xRDE/SS) calculates the number of sectors that are secured for the root directory. Therefore, the formula (TS-RSC-SF-ceil($32 \times$RDE/SS)) has the value obtained by subtracting the number of sectors in the management region from the total number of sectors, that is, the number of sectors in the user data region. The number of clusters that can be secured in the user data region can be calculated as the integer part of the value obtained by dividing the number of sectors in the user data region by SC. In order to secure special FAT entries relating to the management region, 2 further is added.

The FAT file system is a file system that is widely used. In some operating systems, the lower limit on the number of valid clusters is calculated by Formula 1. Thus, when a storage medium with less than a certain capacity, that is, a storage medium with a total number of sectors TS smaller than a certain value is used in the FAT file system, the cluster size should be made small in order to enlarge the total number of clusters. However, when the recording medium is a semiconductor memory pack device, it is not easy to change the cluster size since it is preferable that the cluster size matches the size of the erase block of the semiconductor memory pack device. Therefore, a small-capacity storage medium with a cluster size limitation cannot be used with an operating system having a minimum number of clusters.

Thus, in this embodiment, when a small-capacity storage medium that can secure only the number of clusters below the range supported by the operating system is used in the FAT file system, the above problem is avoided by listing a value that is larger than the number of actually existing sectors in the total number of sectors TS of the boot sector. More specifically, a small-capacity storage medium can be used with an operating system with a limitation by setting the total number of sectors TS to a value that is larger than the value that is calculated by the following Formula 2, when formatting the small-capacity storage medium. Here, LS refers to the lower limit on the number of clusters that is regulated by the operating system.

## Formula 2

$$(LS - 2) \times SC + RSC + SF + ceil\left(\frac{32 \times RDE}{SS}\right)$$

Formula 2 is derived by taking the solution of Formula 1 as LS and solving the formula for TS.

When the total number of sectors obtained by Formula 2 is set in the boot sector, the FAT entries in the FAT include entries that can be associated with actually existing clusters and entries that cannot be associated with actually existing clusters. In FIG. 8, the number of clusters that exist in the user data region is referred to as N, and the number of valid clusters that are calculated by the total number of sectors TS is referred to as M. FAT entries 801 that can be associated with actually existing clusters range from FAT entries No. 1 to N, and FAT entries 802 that cannot be associated with actually existing clusters range from FAT entries No. N+1 to M.

In this embodiment, when formatting a small-capacity storage medium in the FAT file system, all bits are set to 1, indicating an end of file, in all FAT entries 802 that cannot be associated with actually existing clusters. This is because when writing a file into the FAT file system in which the total number of sectors is overstated, if the FAT entries 802 that cannot be associated with actually existing clusters include bit strings representing an unallocated state, the file system may try to write data into a non-existing cluster, and thus an error might occur. If data appears to be already allocated in clusters pointed to by the FAT entries 802 that cannot be associated with actually existing clusters, then non-existing clusters will not be written into when the file system searches for a free region in the volume in order to write the file.

In the FAT 12 and FAT 16 file systems, most operating systems calculate the free space in the storage medium that is informed to the user by counting the FAT entries containing a bit string representing an unallocated state. Thus, according to this embodiment, it is possible to provide the user with accurate information of the free space. In the FAT 32 file system, the number of free clusters that can be obtained on the logical volume is listed in a reserved sector, and most operating systems provide the user with information of the free space of the disk based on this information. In this embodiment, when formatting a storage medium in the FAT file system, the value obtained by subtracting the number of FAT entries 802 that cannot be associated with actually existing clusters from the total number of clusters calculated from the total number of sectors TS is written into the reserved sector as the number of free clusters, and thus accurate information of the free space is provided.

By constructing the FAT file system according to the above-described method, it becomes possible to write onto and read from a small-capacity storage medium with a cluster size limitation even in an operating system with a lower limit on FAT entries. Furthermore, it is also possible to provide the user with accurate information of free space. In Embodiment 5, the bit strings written into the FAT entries 802 that cannot be associated with actually existing clusters are bit strings representing an end of file. However, it is possible to use any bit string that does not represent an unallocated state such as a bit string representing a defective sector.

*Embodiment 6*

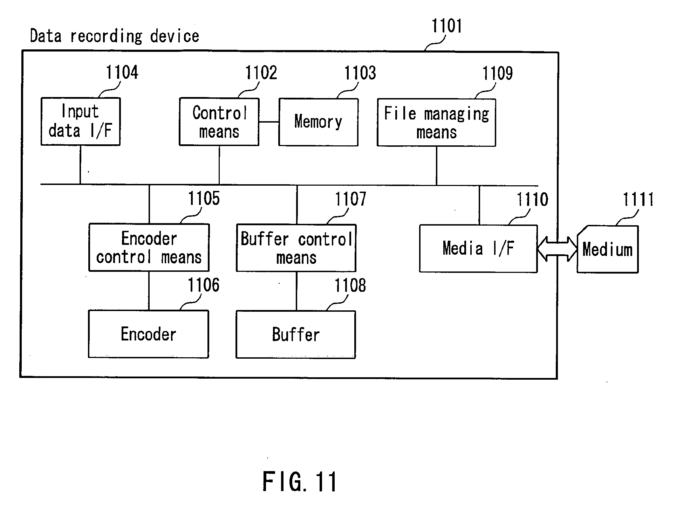

Lastly, another embodiment of the invention will be described with reference to FIG. 11.

FIG. 11 is a block diagram showing a configuration of a data recording device according to Embodiment 6. In FIG. 11, numeral 1101 denotes a data recording device, numeral 1102 denotes a control portion, numeral 1103 denotes a memory, numeral 1104 denotes an input data I/F, numeral 1105 denotes an encoder control portion, numeral 1106 denotes an encoder, numeral 1107 denotes a buffer control portion, numeral 1108 denotes a buffer, numeral 1109 denotes a file management portion, numeral 1110 denotes a media I/F, and numeral 1111 denotes a medium. It should be noted that the medium 1111 is the semiconductor memory pack device 120 that was described in Embodiment 1, for example.

The control portion 1102 controls the entire data recording device 1101 by using the memory 1103. The input data I/F 1104 receives data that has been input from the outside.

The encoder control portion 1105 receives the data that has been input from the input data I/F 1104, encodes the data by controlling the encoder 1106, and sends the encoded data to the buffer control portion 1107. It should be noted that the encoder control portion 1105 can obtain information from the encoder 1106 and forward the information to the control portion 1102. Examples of the information from the encoder 1106 include, for example, information indicating that data for 1 GOP (group of pictures) is completely encoded when encoding video data into MPEG (moving pictures coding experts group).

The buffer control portion 1107 stores the encoded data that has been received from the encoder control portion 1105 in separate regions of the buffer 1108 according to the data types. The buffer control portion 1107 monitors the amount of the data that is stored in the buffer 1108, and sends a message to the control portion 1102 when the amount has reached a certain level. When receiving the message, the control portion 1102 sends a data recording request to the file management portion 1109.

The file management portion 1109 manages files that are recorded in the medium 1111. The file management portion 1109 reads out file system management information from the medium 1111 via the media I/F 1110, and stores the information in the memory 1103. When receiving the data recording request from the control portion 1102, the file management portion 1109 searches for a free region with reference to the file system management information. When a region is found, the file management portion 1109 sends a data recording command to the medium 1111 to record the data into the region. Simultaneously with this process, the file management portion 1109 writes information of the recorded data, such as the recording position or the data amount, into the file system management information that is stored in the memory 1103.

The file system management information that is stored in the memory 1103 should be backed up to the medium 1111 in predetermined intervals, since there might be an unexpected event, such as the power source of the recording device 1101 failing. When the file system management information is not backed up to the medium 1111, for example, there is no way of knowing the recording position or the data amount of the recorded data, and thus the state becomes the same as that in which no recording was performed.

On the other hand, when the file system management information is frequently backed up to the medium 1111, in a medium with an upper limit on the number of rewriting operations, the number of rewriting operations soon may exceed the upper limit. Furthermore, the process for rewriting the file system management information lowers the access efficiency of the medium 1111. Thus, it is important to back up the file system management information to the medium 1111 at an appropriate timing.

Hereinafter, the timing to back up the file system management information will be described with two examples, that is, a case that audio data and video data are recorded simultaneously into different files, and a case that audio data and video data are recorded into one file.

First, the case that audio data and video data are recorded simultaneously into different files will be described.

When audio data and video data are recorded into different files, even if both of them are input into the recording device 1101 simultaneously, they are not simultaneously recorded onto the medium 1111. This is because the bit rate of video data is higher than the bit rate of audio data, and thus the amount of the video data that is stored in the buffer 1108 reaches a certain level sooner than that of the audio data, and the video data is recorded first.

Since audio data and video data constitute a clip together, when only video data is recorded onto the medium 1111, the video data generally becomes meaningless.

Therefore, in this embodiment, when audio data and video data are recorded simultaneously into different files, every time when the audio data is recorded onto the medium 1111, the file system management information is backed up to the medium 1111. More specifically, the recording of data with the lowest bit rate triggers the backup of the file system management information.

As described above, the buffer control portion 1107 monitors the buffer 1108 according to the data types, and sends a message to the control portion 1102 when the amount of the data has reached a certain level. The control portion 1102 knows which data has the lowest bit rate among the data types that currently are being recorded. In this example, the audio data is the data that has the lowest bit rate. When receiving the message that the amount of the audio data accumulated in the buffer 1108 has reached a certain level, the control portion 1102 sends a request to record the audio data and a request to update the file system management information to the file management portion 1109. If the data recording units are set to a common multiple of the size obtained by adding up the sizes of the erase blocks of the semiconductor memory cards 123 to 126 that operate in parallel in the medium 1111 (the semiconductor memory pack device 120) and the data management size of the file management portion 1109, then the above-noted "amount of a certain level" refers to an integral multiple of the data recording unit.

As described above, when audio data and video data are recorded simultaneously into different files, if file system management information is backed up to a medium every time when the audio data, which has a low bit rate, is recorded, then it is possible to adopt measures to protect against a disconnection of the power source without needlessly increasing the number of rewriting operations of the medium.

Next, the case that audio data and video data are recorded into one file as an MPEG system stream will be described.

When recording an MPEG system stream, data is compressed between frames, the compression being completed in units of 1 GOP, and thus data cannot be normally decoded and reproduced when the data is recorded at a unit that is shorter than 1 GOP. Thus, in most cases, it is meaningless to back up file system management information to a medium at a time when data of less than 1 GOP has been recorded. Therefore, in this embodiment, in the case of recording the MPEG system stream onto a medium as one file, file system management information is updated when data for an integral multiple of 1 GOP has been recorded. Thus, the file system management information is prevented from being rewritten more often than necessary, and it is possible to extend the rewriting life of the medium.

**Claims**

1. A data recording device that records data into a semiconductor memory pack device that includes a plurality of flash memories performing recording operations in parallel, the data recording device comprising:

   a file management portion for managing data that is to be recorded into the semiconductor memory pack device as a file;

   wherein the file management portion sets a data recording unit of data that is to be supplied to the semiconductor memory pack device to a common multiple of a size obtained by adding up the sizes of erase blocks of the plurality of flash memories and a data management size of the file management portion.

2. The data recording device according to claim 1,
   wherein a data recording unit is an integral multiple of the size obtained by adding up the sizes of the erase blocks of the plurality of flash memories; and
   wherein a data management unit of the file management portion has the same size as the data recording unit.

3. The data recording device according to claim 1 or 2,
   wherein the file management portion lets each data recording unit include only data of the same file.

4. The data recording device according to claim 1 or 2,
   wherein the file management portion records data only when the semiconductor memory pack device includes free space that is equivalent to the data recording unit.

5. The data recording device according to claim 1 or 2,
   wherein when data of different files is recorded in the data recording unit, the file management portion sorts recording data in such a manner that the data recording unit includes only data of the same file.

6. The data recording device according to claim 1 or 2,
   wherein the semiconductor memory pack device is provided with a region into which file management information of the file management portion is recorded; and
   wherein when the file management portion records at least two files of an audio data file and a video data file simultaneously and in parallel into the semiconductor memory pack device, the file management information that is recorded in the semiconductor memory pack device is updated at a time when an amount of audio data accumulated as data that is to be supplied to the semiconductor memory pack device becomes an integral multiple of the data recording unit.

7. The data recording device according to claim 1 or 2,
   wherein when the file management portion records an MPEG stream into a file, the file management information of the file management portion is updated at a time when an amount of recorded data becomes an integral multiple of 1 GOP.

8. The data recording device according to claim 1 or 2,
   wherein the flash memories are mounted on the semiconductor memory pack device as semiconductor memory cards.

CPU 111

Main memory 112

Card connector 113

Logical address

Command    Data

Data recording device 110

Multi-card access control portion 121

Work memory 122

Semiconductor memory card #1 123

Semiconductor memory card #2 124

Semiconductor memory card #3 125

Semiconductor memory card #4 126

Semiconductor memory pack device 120

FIG. 1

Management unit

Erase block
220

| 201 |
| 202 |
| 203 |
| 204 |

Erase block
230

| 205 |
| 206 |
| 207 |
| 208 |

Erase block
240

| 209 |
| 210 |
| 211 |
| 212 |

FIG. 2A

| 201 |
| 202 |
| 203 |
| 204 |

Recording region
250

| 205 |
| 206 |
| 207 |
| 208 |

Recording region
260

| 209 |
| 210 |
| 211 |
| 212 |

FIG. 2B

| 201 |
| 202 |
| 203 |
| 204 |

Recording region
270

| 205 |
| 206 |
| 207 |
| 208 |

| 209 |
| 210 |
| 211 |
| 212 |

Recording region
280

FIG. 2C

Logical address of
semiconductor
memory pack device

Logical address of
individual
semiconductor
memory cards      n=1

| 0000 | Erase block of semiconductor memory card #1 301 (16KB) | 0000 |
| 3FFF | | 3FFF |
| 4000 | Erase block of semiconductor memory card #2 302 (16KB) | 0000 |
| 7FFF | | 3FFF |
| 8000 | Erase block of semiconductor memory card #3 303 (16KB) | 0000 |
| BFFF | | 3FFF |
| C000 | Erase block of semiconductor memory card #4 304 (16KB) | 0000 |
| FFFF | | 3FFF |

Recording
unit of
semiconductor
memory pack
device

Cluster
size
(64KB)

305

FIG. 3

Logical address of
semiconductor
memory pack device

Logical address of
individual
semiconductor
memory cards    n=4

| | | | |
|---|---|---|---|
| 0000 | Erase block of semiconductor memory card #1 | 0000 | |
| 3FFF | 401 (16KB) | 3FFF | |
| 4000 | Erase block of semiconductor memory card #2 | 0000 | |
| 7FFF | 402 (16KB) | 3FFF | |
| 8000 | Erase block of semiconductor memory card #3 | 0000 | |
| BFFF | 403 (16KB) | 3FFF | |
| C000 | Erase block of semiconductor memory card #4 | 0000 | |
| FFFF | 404 (16KB) | 3FFF | |

Recording
unit of
semiconductor
memory pack
device

Cluster
size
(64KB)

405

FIG. 4

n=4

| | | |
|---|---|---|
| Erase block of semiconductor memory card #1 | | Free cluster | Cluster size |
| Erase block of semiconductor memory card #2 | | Free cluster | |
| Erase block of semiconductor memory card #3 | Recordable | Free cluster | |
| Erase block of semiconductor memory card #4 | | Free cluster | |
| Erase block of semiconductor memory card #1 | | Free cluster | |
| Erase block of semiconductor memory card #2 | Unrecordable | Used cluster | |
| Erase block of semiconductor memory card #3 | | Free cluster | |
| Erase block of semiconductor memory card #4 | | Free cluster | |
| Erase block of semiconductor memory card #1 | | Free cluster | |
| Erase block of semiconductor memory card #2 | | Free cluster | |

Recording unit of semiconductor memory pack device 501

Recording unit of semiconductor memory pack device 502

FIG. 5

n=4

| Recording unit of semiconductor memory pack device | Erase block of semiconductor memory card #1 | File #1 | Cluster size |
| | Erase block of semiconductor memory card #2 | File #2 | |
| | Erase block of semiconductor memory card #3 | File #3 | |
| | Erase block of semiconductor memory card #4 | File #4 | |
| | Erase block of semiconductor memory card #1 | File #1 | |
| | Erase block of semiconductor memory card #2 | File #2 | |
| | Erase block of semiconductor memory card #3 | File #3 | |
| | Erase block of semiconductor memory card #4 | File #4 | |
| | Erase block of semiconductor memory card #1 | File #1 | |
| | Erase block of semiconductor memory card #2 | File #2 | |

FIG. 6

n=4

| Recording unit of semiconductor memory pack device | Erase block of semiconductor memory card #1 | | File #1 | Cluster size |
| Erase block of semiconductor memory card #2 | File #1 |
| Erase block of semiconductor memory card #3 | File #1 |
| Erase block of semiconductor memory card #4 | File #1 |
| Erase block of semiconductor memory card #1 | File #2 |
| Erase block of semiconductor memory card #2 | File #2 |
| Erase block of semiconductor memory card #3 | File #2 |
| Erase block of semiconductor memory card #4 | File #2 |
| Erase block of semiconductor memory card #1 | File #3 |
| Erase block of semiconductor memory card #2 | File #3 |

FIG. 7

Boot sector

Total Number of sectors
in filesystem (TS)

$M=((TS-RSC-SF-ceil(32*RDE/SS))/SC)+2$

FAT

| 1 | 2 | 3 | | | | | |
| | | | | | | | |
| | | | | | | | |
| | | | | | N | N+1 | |
| | | | | | | | |
| | | | | | | | M |

801

802

| User Data Area | cluster 1 |
| | cluster 2 |
| | cluster 3 |
| | . |
| | . |
| | . |
| | cluster N |

FIG. 8

Number of sectors

LSN

| | Boot sector | 1sector | 0×00000000 |
| RSC | Reserved sectors | | |
| SF | FAT (1) | | |
| SF | FAT (2) | | |
| Ip(RDE*32/SS) | Root Directory | | |
| | cluster | | |
| | cluster | User data region |
| | . . . | |

TS

FIG. 9

1002   1003   1004   1005

| A | B | C | D | E |
| B | C | D | 0×FF | 0×00 |

FAT

User Data Area

cluster No. A

cluster No. B

File

1001

cluster No. C

cluster No. D

cluster No. E

FIG. 10

Data recording device                                          1101

FIG. 11

| Bite position (BP) | Name | Note | Abbreviation |
|---|---|---|---|
| 1 to 3 | Secured for system | | |
| 4 to 11 | Creation system ID | | |
| 12 to 13 | Number of bytes in data field of sector | | SS |
| 14 | Number of sectors per cluster | | SC |
| 15, 16 | Reserved sector count | | RSC |
| 17 | Number of FATs | | FN |
| 18, 19 | Number of root directory entries | | RDE |
| 20, 21 | Total number of sectors | 65535 and less:<br>total number of sectors<br>65536 and more: 0 | TS |
| 22 | Media descriptor | | |
| 23, 24 | Number of sectors per FAT | | SF |
| 25, 26 | Number of sectors per track | | SPT |
| 27, 28 | Number of surfaces | - | NOS |
| 29 to 32 | Secured for system | | |
| 33 to 36 | Total number of sectors | BP20, 21=0:<br>total number of sectors<br>Others: not regulated | TS |
| 37 | Secured for system | | |
| 38 | Secured | | |
| 39 | Extended boot record signature | | |
| 40 to 43 | Volume ID number | | |
| 44 to 54 | Volume label | | |
| 55 to 62 | File system type | | |
| 63 to 512 | Secured for system | | |

# FIG. 12

Data recording device 110

Input data I/F 1104

Control means 1102

Memory 1103

File managing means 1109

Encoder control means 1105

Buffer control means 1107

Media I/F 1110

Medium 1111

Encoder 1106

Buffer 1108

FIG. 13

Recording unit of
semiconductor memory pack device

Before sorting | #1-1 | #2-1 | #3-1 | #4-1 | #1-2 | #2-2 | #3-2 | #4-2 | #1-3 | · · ·

One cluster

#1-1    #3-1    #1-2    #3-2    #1-3

#2-1    #4-1         #2-2    #4-2

Temporary buffer

After sorting | #1-1 | #1-2 | #1-3 | #1-4 | #2-1 | #2-2 | #2-3 | #2-4

Recording unit of
semiconductor memory pack device

FIG. 14

28

<div align="center">

**INTERNATIONAL SEARCH REPORT**

</div>

| | International application No. |
|---|---|
| | PCT/JP2004/005575 |

**A. CLASSIFICATION OF SUBJECT MATTER**
Int.Cl⁷ G06F12/00, G06F12/02, G06F12/06, G06K17/00

According to International Patent Classification (IPC) or to both national classification and IPC

**B. FIELDS SEARCHED**

Minimum documentation searched (classification system followed by classification symbols)
Int.Cl⁷ G06F12/00, G06K17/00

Documentation searched other than minimum documentation to the extent that such documents are included in the fields searched

| | | | |
|---|---|---|---|
| Jitsuyo Shinan Koho | 1922–1996 | Toroku Jitsuyo Shinan Koho | 1994–2004 |
| Kokai Jitsuyo Shinan Koho | 1971–2004 | Jitsuyo Shinan Toroku Koho | 1996–2004 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | JP 2000-57038 A (Sony Corp.),<br>25 February, 2000 (25.02.00),<br>Par. Nos. [0032] to [0090]; Figs. 1 to 3<br>(Family: none) | 1-8 |
| Y | JP 6-266596 A (Hitachi, Ltd.),<br>22 September, 1994 (22.09.94),<br>Par. Nos. [0009] to [0017], [0047] to [0049];<br>Fig. 5<br>& US 2001/0007119 A1 & KR 009616397 B | 1-8 |
| Y | JP 5-282880 A (Toshiba Corp.),<br>29 October, 1993 (29.10.93),<br>Par. Nos. [0156] to [0157]; Fig. 20<br>& US 005559956 A & US 005673383 A | 1-8 |

☐ Further documents are listed in the continuation of Box C.   ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 27 July, 2004 (27.07.04) | 17 August, 2004 (17.08.04) |

| Name and mailing address of the ISA/<br>Japanese Patent Office | Authorized officer |
|---|---|
| Facsimile No. | Telephone No. |

Form PCT/ISA/210 (second sheet) (January 2004)